# EUROPEAN PATENT APPLICATION

(11) **EP 3 031 945 A1**
(43) Date of publication of application: **15.06.2016**
(21) Application number: 14197527.6
(22) Date of filing: 12.12.2014
(51) Int. Cl.: C23C 14/08, C23C 14/20, A01N 25/00, A01N 25/26, C08J 7/06

(54) **Method for preparation of composite composition**

(71) Applicant: Tsao, Cheng-Shang, Taipei City 110 (TW)
(72) Inventor: Tsao, Cheng-Shang, Taipei City 110 (TW)
(74) Representative: Becker Kurig Straus

(57) **Abstract**

A method for preparation of a composite composition (1,2) involves performing magnetron sputtering deposition to nanolize at least one target such as silver or titanium dioxide or zinc oxide and to deposit the target over surfaces of a plastic matrix (11,21), so as to obtain a composite matrix (10), and using pressing or blowing or injection forming to make the composite matrix (10) into a composite composition (1,2). Thereby, the method ensures that the target is evenly distributed over the film, making it a composite composition (1,2) that is antibacterial, capable of generating anions and far infrared rays or highly ventilative.

## Description

### BACKGROUND OF THE INVENTION

### 1. Field of the Invention

The present invention relates to methods for for preparation of composite compositions, and more particularly to a method for preparation of a composite composition that is antibacterial, capable of generating anions or far infrared rays, or highly ventilative composite composition.

### 2. Description of Related Art

Conventionally, for preparing a composite composition that is antibacterial or capable of generating anions, nanoparticles of silver, titanium dioxide or zinc oxide are mixed with plastic material (liquid) to form plastic masterbatch that is antibacterial and capable of generating anions and far infrared rays, and the masterbatch is then made into a plastic product through an injection process. However, the known method is in practice not economic. Since there are so many types of plastic materials, a manufacturer has to prepare and stock as many types of materials as possible, and mix the materials separately with nanoparticles of silver, titanium dioxide or zinc oxide to form plastic masterbatch that is antibacterial and capable of generating anions in advance. Upon receiving an order from a customer, the manufacture takes the plastic material selected by the customer, according to the required antibacterial level and capability of generating anions, and mixes the plastic masterbatch that is antibacterial and capable of generating anions with a plastic masterbatch made of the same material in a specific ratio, and then make the mixture into plastic products by means of injection. In this case, the manufacturer has to stock large quantities of various plastic masterbatches, including the plastic masterbatches that are antibacterial and capable of generating anions. This known approach thus requires considerable inventory and costs, and the multi-stage injection makes the whole manufacturing process complicated and time-consuming.

Hence, many manufacturers have turned to an alternative where nanoparticles that are antibacterial and capable of generating anions are mixed with plastic masterbatch directly, and then injection is performed on the mixture to form plastic products that are antibacterial and capable of generating anions. However, there are differences between the resulting products in antibacterial level and capability of generating anions because the uneven distribution of nanoparticles over the surface of the plastic masterbatch. It is common that there are lumps of nanoparticles concentrated on a part of the surface of the plastic masterbatch, and some plastic masterbatches may have plural lumps of nanoparticles. This varies the ratio between the plastic masterbatch and the nanoparticles, and adversely affects the quality of the product made by injection.

Thus, the known methods fail to ensure even distribution of nanoparticles and need to be improved.

### BRIEF SUMMARY OF THE INVENTION

The primary objective of the present invention is to provide a method for preparation of a composite composition, which method helps to reduce material inventory and lower costs, while ensuring nano silver, nano titanium oxide or nano zinc oxide evenly form over surfaces of plastic particles to become a composite composition that is antibacterial, capable of generating anions or far infrared rays, or highly ventilative.

For achieving the foregoing objective, the disclosed method involves performing vapor deposition on a plastic matrix to make at least one target deposited over the surfaces of the plastic matrix, so as to obtain a composite matrix, and using an integratedly forming process to make plural said composite matrixes into a composite composition.

Therein, the plastic matrix is made of polyethylene (PE), polypropylene (PP), polyurethane (PU), polyvinyl chloride (PVC), polymethylmethacrylate (PMMA), acrylonitrile butadiene styrene copolymers (ABS), nylon, polyethylene terephthalate (PET), polycarbonate (PC), polyvinylidene fluoride (PVDF), epoxy, or phenol formaldehyde resin.

Therein, the vapor deposition process is a sputtering deposition, and particularly a magnetron sputtering deposition process.

Therein, the target for the vapor deposition process is silver, titanium dioxide, or zinc oxide, and the target is formed by the vapor deposition process into nanoparticles of nano silver, nano titanium oxide, or nano zinc oxide.

Therein nano-scale gaps are formed between the nanoparticles or between the nanoparticles and a contacting surface of the plastic matrix.

Therein the forming process is pressing, blowing, injecting, or blasting.

Therein, the composite composition of Step (C) is a composite film, a composite fiber or a composite woven yarn.

Therein, the forming process of Step (C) is a compression molding process.

The composite composition formed using the compression molding process has a predetermined geometric shape.

Therein, the plastic matrix is in a form of particles, strips, sheets or films.

Thereby, the present invention uses the sputtering deposition process to nanolize the target such as silver, titanium dioxide, or zinc oxide into nano silver, nano titanium oxide, or nano zinc oxide, and to evenly form the target over the surfaces of the plastic matrix (the matrix may be in the form of particles, strips, sheets or films). In virtue of the nanoparticles of silver, titanium dioxide, or zinc oxide, the composite film is antibacterial or capable of generating anions or far infrared rays. In addition, since the sputtering deposition process makes the nanoparticles of silver, titanium dioxide or zinc oxide evenly distributed over the plastic particles or plastic films, so each resulting composite particle or composite composition has uniformly distributed nanoparticles of nano silver, nano titanium oxide or nano zinc oxide thereon. With the even distribution, the quality of the product is stable and the color saturation of the composite composition is enhanced.

Additionally, nano-scale gaps are formed between the nanoparticles or between the nanoparticles and the contacting surface of the plastic matrix. These nano-scale gaps allow the disclosed composite composition to be more ventilative.

The following preferred embodiments when read with the accompanying drawings are made to clearly exhibit the above-mentioned and other technical contents, features and effects of the present invention. Through the exposition by means of the specific embodiments, people would further understand the technical means and effects the present invention adopts to achieve the above-indicated objectives. However, the accompanying drawings are intended for reference and illustration, but not to limit the present invention.

### BRIEF DESCRIPTION OF THE SEVERAL VIEWS OF THE DRAWINGS

FIG. 1 is a flowchart of a method for preparation of a composite composition according to one preferred embodiment of the present invention.
FIGs. 2(A) through 2(C) are schematic drawings illustrating the method according to the first preferred embodiment of the present invention, showing changes of the plastic material after each step.
FIGs. 3 (A) through 3(B) are schematic drawings illustrating the method for preparation of a composite composition according to a second preferred embodiment of the present invention, showing changes of the plastic material after each step.
FIG. 4 is a perspective view of one composite composition according to the present invention, wherein the composite composition is in the form of woven yarn.
FIG. 5 a perspective view of another composite composition according to the present invention, wherein the composite composition is in the form of fiber.
FIG. 6 is a schematic drawing showing the composite composition made using the method of the present invention after a compression molding process.
FIG. 7 is an enlarged view of the composite composition made using the method of the present invention, showing nano-scale gaps in the composite composition.
FIG. 8 is an enlarged view of the composite composition made using the method of the present invention, showing nano-scale gaps in the composite composition.

### DETAILED DESCRIPTION OF THE INVENTION

For further illustrating the means and functions by which the present invention achieves the certain objectives, the following description, in conjunction with the accompanying drawings and preferred embodiments, is set forth as below to illustrate the implement, structure, features and effects of the subject matter of the present invention.

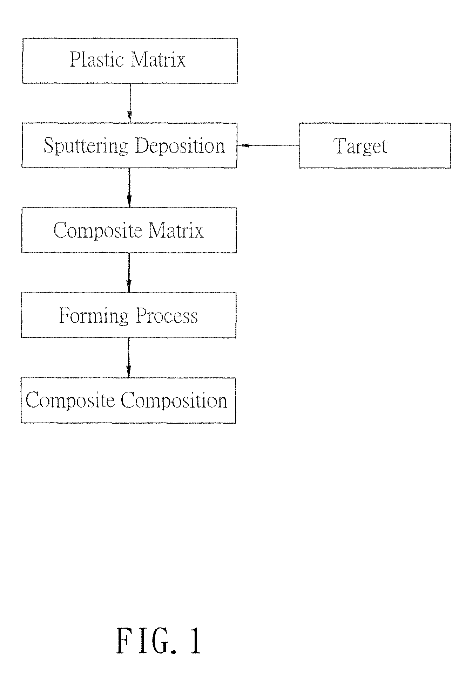

Referring FIG. 1, according to a first preferred embodiment of the present invention, a method for preparation of a composite composition comprises the following steps:
Step A) providing a plastic matrix 11;
Step B) performing a vapor deposition process on the plastic matrix 11 to make at least one target deposited over the surfaces of the plastic matrix 11, so as to obtain a composite matrix 10; and
Step C) using an integratedly forming process to make the composite matrix 10 into a composite composition 1.

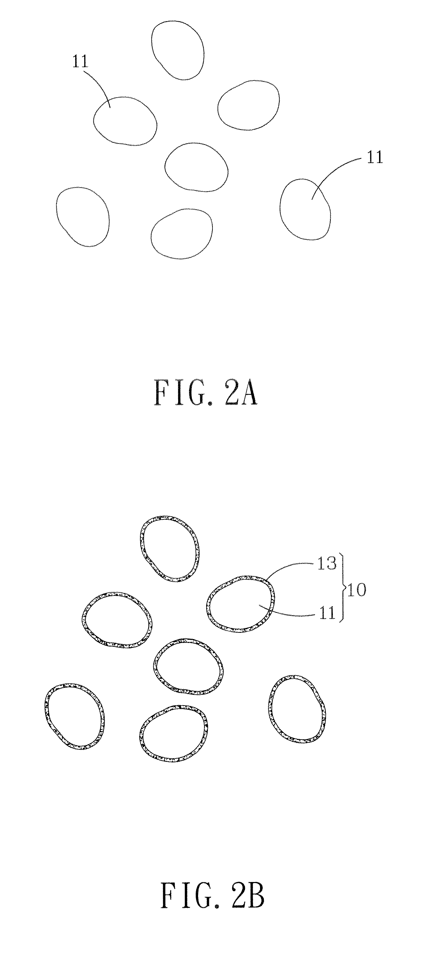

The method of the first preferred embodiment is now described in detail with reference to FIGs. 2 (A) through (C).

In Step A), the plastic matrix 11 is in the form of particles, films, strips or sheets, and the plastic matrix 11 is made of polyethylene(PE), polypropylene (PP), polyurethane (PU), polyvinyl chloride (PVC), polymethylmethacrylate (PMMA), acrylonitrile butadiene styrene copolymers (ABS), nylon, polyethylene terephthalate (PET), polycarbonate (PC), polyvinylidene fluoride (PVDF), epoxy, or phenol formaldehyde resin.

In Step B), the vapor deposition process is a sputtering deposition process, which may be particularly a magnetron sputtering deposition process. The target for the vapor deposition process is silver, titanium dioxide, zinc oxide, or other metals that in the form of nanoparticles become antibacterial, or capable of generating anions far infrared rays.

In the Step C), the forming process includes pressing, blowing, injecting, blasting and/or cutting.

To sum up, in the first preferred embodiment, the plastic matrix 11 is plastic particles 11, and according to the disclosed method receive the magnetron sputtering deposition process to have at least one of silver, titanium dioxide and zinc oxide as a target in the form of nanoparticles 13, e.g. nano silver, nano titanium oxide, nano zinc oxide, evenly deposited on the surfaces of the plastic particles 11 so as to form composite particles 10. Then the composite particles 10 are processed through pressing, blowing, injection forming, blasting or molding into the composite composition 1, thereby providing the composite composition 1 that is antibacterial, or capable of generating anions or far infrared rays, or is antibacterial and capable of generating anions and far infrared rays. Since the nanoparticles 13 are formed on the surfaces of the plastic particles 11 by means of magnetron sputtering deposition, the nanoparticles 13 are distributed more evenly than what can be achieved by using the traditional mixing process. With the even distribution, the quality of the product is stable and the color saturation of the composite composition 1 is enhanced. Bedsides, since the disclosed method makes the composite product that is antibacterial, or capable of generating anions or far infrared rays, or is antibacterial and capable of generating anions and far infrared rays by performing a single forming process on the composite particles 10, there is no need to stock various martials in large quantities, and the whole manufacturing process can be simplified, thereby reducing manufacturing costs.

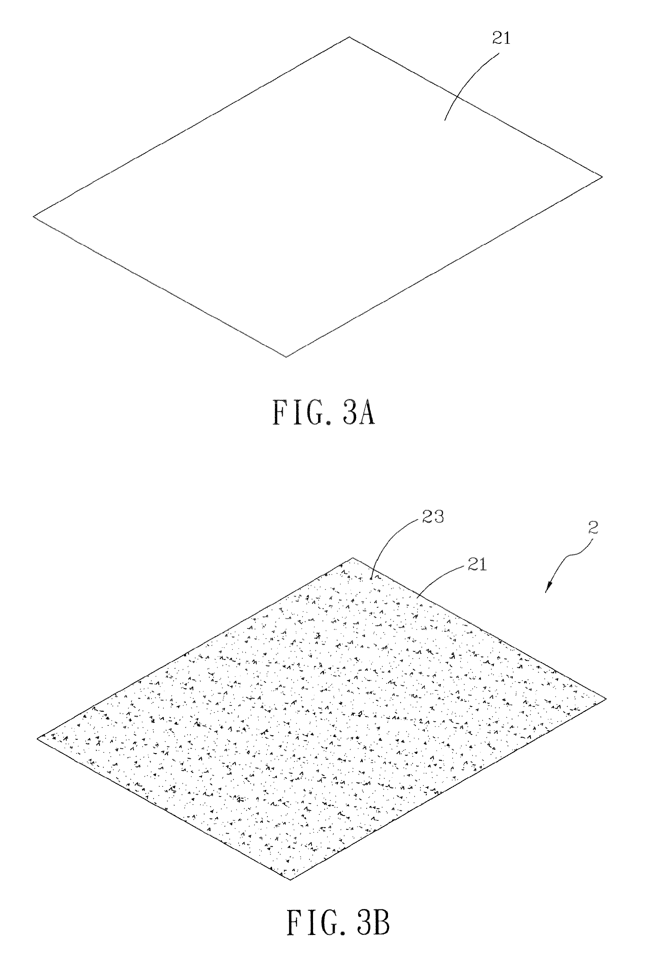

Referring to FIGs. 3(A) through 3(B), a second preferred embodiment of the present invention is also a method for preparing the composite composition, and different from the first preferred embodiment by having the plastic matrix 11 in the forms of films, strips or sheets instead of particles. In the method of the second preferred embodiment,

First, a sputtering deposition process is performed to nanolize at least one target, such as silver, titanium dioxide or zinc oxide into nanoparticles 23 of nano silver, nano titanium oxide or nano zinc oxide and to evenly form the nanoparticles 23 over the surfaces of the plastic film 21. Afterward, pressing, blowing, injecting, blasting or cutting is performed to further process the plastic film 21 coated with the nanoparticles 23, thereby obtaining the composite composition 2 that is antibacterial, or capable of generating anions or far infrared rays, or is antibacterial and capable of generating anions and far infrared rays.

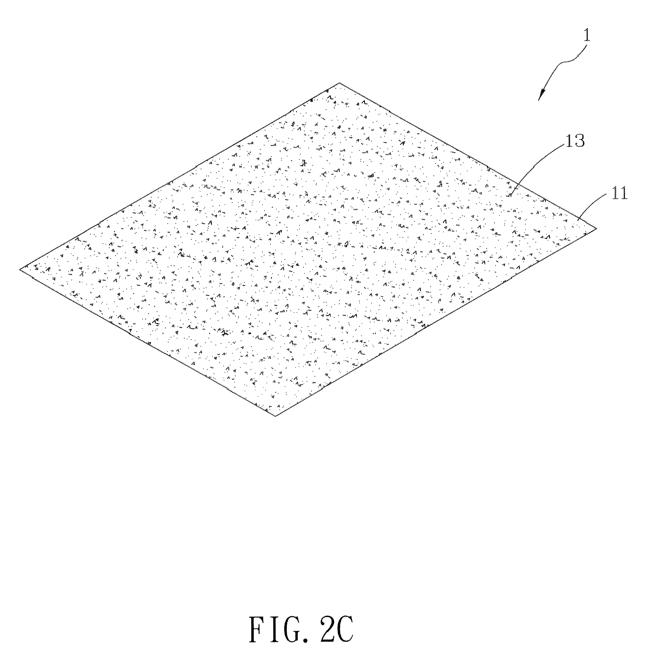

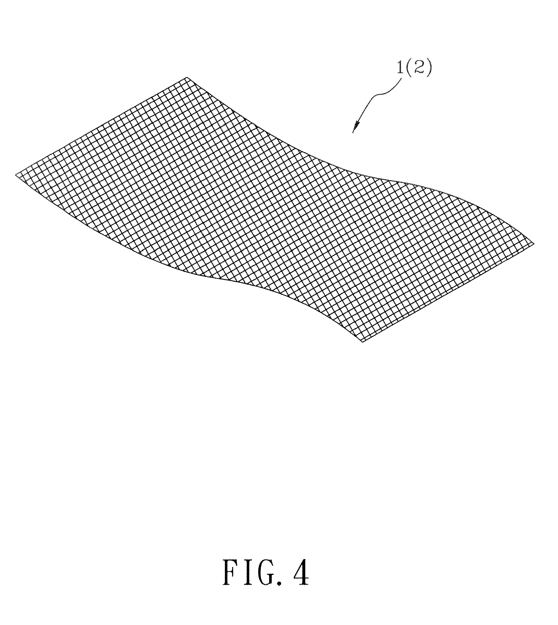

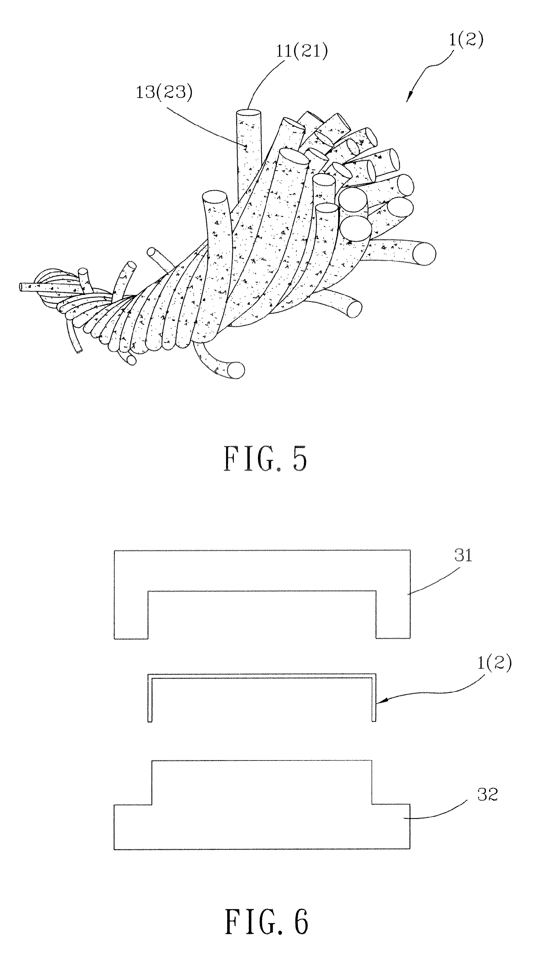

Referring to FIG. 2 through FIG. 5, by using the disclosed method, the resulting composite composition 1 or 2 may be composite film, composite fiber or composite woven yarn, for different applications. As shown in FIG. 6, the forming process used in the present invention may be a compression molding process that involves closing an upper mold half 31 to a lower mold half 32, so that the composite composition 1 or 2 can have a predetermined geometric shape, such as a shell for housing something.

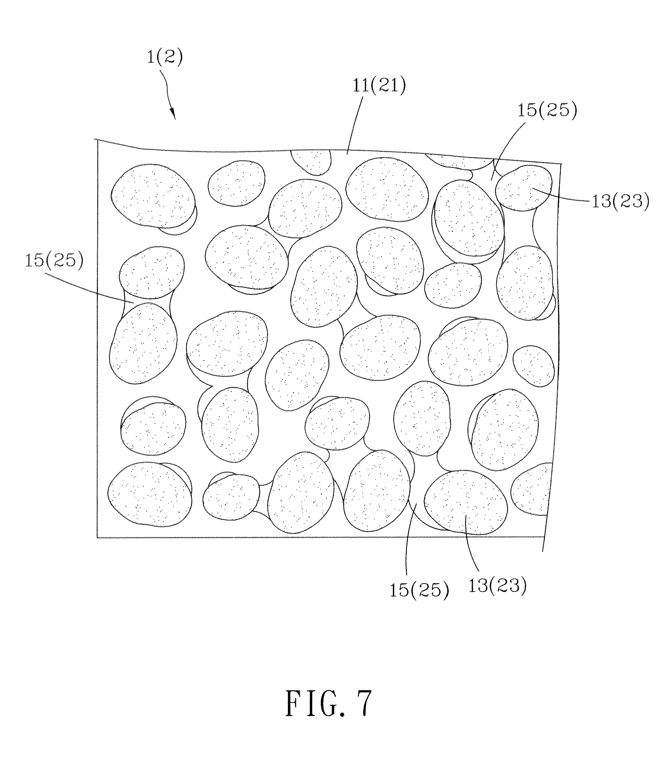

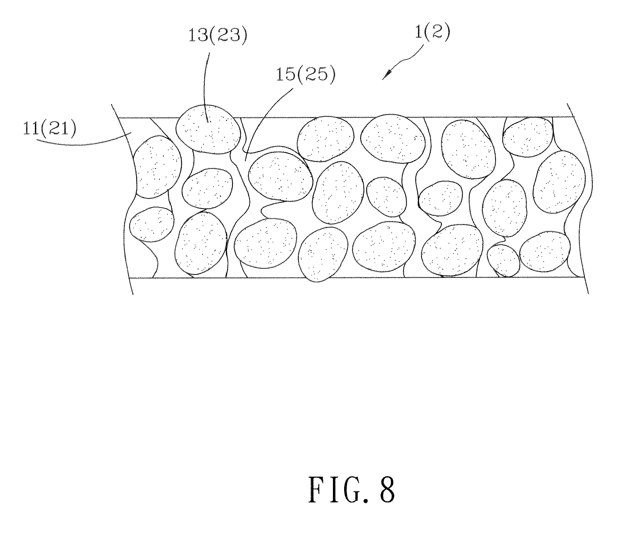

Moreover, referring to FIG. 7 and FIG. 8, in the composite compositions 1, 2 made using the methods as proposed in the first and second preferred embodiments of the present invention, nano-scale gaps 15, 25 are formed between the nanoparticles 13, 23 or between the nanoparticles 13, 23 and the contacting surfaces of the plastic matrixes 11, 21. These nano-scale gaps 15, 25 allow the composite compositions 1, 2 of the present invention to be more ventilative.

To sum up, the method for preparation of the composite composition as disclosed in the present invention uses a magnetron sputtering deposition process to nanolize at least one target such as silver, titanium dioxide or zinc oxide into nanoparticles 13, 23 of nano silver, nano titanium oxide, or nano zinc oxide, and to evenly distribute the nanoparticles 13, 23 over the surfaces of the plastic matrixes 11, 21. Afterward, by using a forming process the composite compositions 1, 2 being antibacterial or capable of generating anions, or being antibacterial and capable of generating anions can be obtained. With the even distribution, the quality of the product is stable and the color saturation of the composite compositions 1, 2 is enhanced. Bedsides, since the disclosed method makes the composite films, composite fiber, composite woven yarn by performing a single press or blowing or injecting or cutting process, there is no need to stock various martials in large quantities, and the whole manufacturing process can be simplified, thereby reducing manufacturing costs.

The present invention has been described with reference to the preferred embodiments and it is understood that the embodiments are not intended to limit the scope of the present invention. Moreover, as the contents disclosed herein should be readily understood and can be implemented by a person skilled in the art, all equivalent changes or modifications which do not depart from the concept of the present invention should be encompassed by the appended claims.

## Claims

1. A method for preparation of a composite composition (1,2), the method comprising the following steps:
A) providing a plastic matrix (11,21);
B) performing a vapor deposition process to form at least one target over surfaces of the plastic matrix (11,21), so as to obtain a composite matrix (10); and
C) using an integratedly forming process to make the composite matrix (10) into a composite composition (1,2).

2. The method of claim 1, wherein the plastic matrix (10) of Step A) is made of polyethylene(PE), polypropylene (PP), polyurethane (PU), polyvinyl chloride (PVC), polymethylmethacrylate (PMMA), acrylonitrile butadiene styrene copolymers (ABS), nylon, polyethylene terephthalate (PET), polycarbonate (PC), polyvinylidene fluoride (PVDF), epoxy, or phenol formaldehyde resin.

3. The method of claim 1, wherein the vapor deposition process of Step B) is a sputtering deposition process.

4. The method of claim 1, wherein the target for the vapor deposition process of Step B) is silver, titanium dioxide, or zinc oxide, and the target is formed by the vapor deposition process into nanoparticles (13,23) of nano silver, nano titanium oxide, nano zinc oxide.

5. The method of claim 4, wherein nano-scale gaps (15,25) are formed between the nanoparticles (13,23) or between the nanoparticles (13,23) and a contacting surface of the plastic matrix (11,21).

6. The method of claim 1, wherein the forming process of Step C) is pressing, blowing, injecting, or blasting.

7. The method of claim 1, wherein the composite composition (1,2) of Step (C) is a composite film, a composite fiber or a composite woven yarn.

8. The method of claim 1, wherein the forming process of Step C) is a compression molding process.

9. The method of claim 8, wherein the composite composition made using the compression molding process has a predetermined geometric shape.

10. The method of claim 1, wherein the plastic matrix (11,21) of Step A) is in a form of particles, strips, sheets or films.
